# EUROPEAN PATENT APPLICATION

(11) **EP 4 525 114 A1**
(43) Date of publication of application: **19.03.2025**
(21) Application number: 22948912.5
(22) Date of filing: 14.09.2022
(51) Int. Cl.: H01M 10/0525, H01M 4/62, H01M 4/583

(54) **MULTI-HIERARCHICAL COMPOSITE MATERIAL PREPARED AT ULTRA-HIGH TEMPERATURE, AND PREPARATION METHOD THEREFOR AND USE THEREOF**

(30) Priority: 29.06.2022 CN 202210750606
(71) Applicant: Tianmulake Excellent Anode Materials Co., Ltd., Liyang, Jiangsu 213330 (CN)
(72) Inventor: SHAO, Jin, Liyang, Jiangsu 213330 (CN); LUO, Fei, Liyang, Jiangsu 213330 (CN)
(74) Representative: Glück Kritzenberger Patentanwälte PartGmbB
(86) International application number: PCT/CN2022/118596
(87) International publication number: WO 2024/000823

(57) **Abstract**

The embodiments of the present invention relate to a multi-hierarchical composite material prepared at an ultra-high temperature, and a preparation method therefor and the use thereof. The multi-hierarchical composite material comprises: a carbon matrix and a nano-silicon-based composite material, wherein the nano-silicon-based composite material is prepared by means of a thermal plasma process, which specifically comprises: bombarding and ionizing a micron-scale silicon powder and one or more substances containing a doping element in a high-frequency plasma processing device to form a plasma gas having a temperature of 5000 K or more, and then cooling same and depositing same into a core, thereby obtaining a nanoscale silicon-based composite material with doping elements uniformly embedded and distributed at an atomic scale; the doping element comprises at least one of C, N, B, P, S, Mg, Ca, Al, Zn, Mn, Ni or Ti; the carbon matrix is a porous carbon material; and the nano-silicon-based composite material is deposited in the porous structure of the carbon matrix.

## Description

This application Claims priority for Chinese patent application No. 202210750606.1, entitled "MULTI-HIERARCHICAL COMPOSITE MATERIAL PREPARED AT ULTRA-HIGH TEMPERATURE, AND PREPARATION METHOD THEREFOR AND USE THEREOF", filed with China National Intellectual Property Administration on June 29, 2022.

### BACKGROUND OF THE INVENTION

### 1. Technical Field

The present present invention relates to the technical field of batteries, in particular to a multi-hierarchical composite material prepared at an ultra-high temperature, and a preparation method therefor and the use thereof.

### 2. Description of Related Art

With the progress of society, there is an increasing demand for high-energy density batteries, and graphite negative electrodes are gradually losing their ability to meet the needs of various devices. Silicon, with a maximum theoretical capacity of 4200 mAh/g, is considered one of the most promising materials to replace graphite negative electrodes. However, silicon undergoes significant volume changes during charge and discharge, which can lead to electrode material pulverization. Additionally, silicon has low intrinsic conductivity, which significantly affects battery performance.

The blending of silicon and carbon materials offers an effective solution to address the aforementioned problem. However, achieving a homogeneous composite of silicon and carbon remains a major challenge. The commonly employed method in the market is through physical-mechanical means, which hinder the uniform dispersion of silicon and carbon materials. While the dispersion of silicon into carbon materials has been achieved through chemical vapor deposition (CVD), this method fails to control the morphology of Si and C. Furthermore, the use of silane in this process poses safety hazards, making it considerably risky.

### BRIEF SUMMARY OF THE INVENTION

The present invention provides a multi-hierarchical composite material prepared at an ultra-high temperature, and a preparation method therefor and the use thereof. The multi-hierarchical composite material prepared at an ultra-high temperature provided by the present invention exhibits a stable structure. Compared to traditional silicon-based materials, the multi-hierarchical structure and interactions among the composite materials make the material have small volume expansion and better cycle performance and rate performance.

In a first aspect, an embodiment of the present invention provides a multi-hierarchical composite material, which comprises a carbon matrix and a nano-silicon-based composite material;
the nano-silicon-based composite material is prepared by means of a thermal plasma process, which specifically comprises: bombarding and ionizing a micron-scale silicon powder and one or more substances containing a doping element in a high-frequency plasma processing device to form a plasma gas having a temperature of 5000 K or more, and then cooling same and depositing same into a core, thereby obtaining a nanoscale silicon-based composite material with doping elements uniformly embedded and distributed at an atomic scale; the doping element comprises at least one of C, N, B, P, S, Mg, Ca, Al, Zn, Mn, Ni or Ti;
the carbon matrix is a porous carbon material; and the nano-silicon-based composite material is deposited in the porous structure of the carbon matrix.

Preferably, the particle size of the nano-silicon-based composite material is 0.1-200 nm, and the nano-silicon-based composite material accounts for 10-90% of the mass of the multi-hierarchical composite material; the mass of the doping elements accounts for 0.1-50% of the mass of the nano-silicon-based composite material; and the mass of the carbon matrix accounts for 10-70% of the mass of the multi-hierarchical composite material.

Preferably, the multi-hierarchical composite material further comprises a carbon shell, an outer layer of the carbon matrix where the nano-silicon-based composite material is deposited is coated with the carbon shell, and the mass of the carbon shell accounts for 0-10% of the mass of the multi-hierarchical composite material.

Preferably, when the multi-hierarchical composite material contains the element C, the solid-state nuclear magnetic resonance (NMR) spectrum of the multi-hierarchical composite material shows that when a silicon peak is between -65 ppm and -140 ppm, there is a Si-C resonance peak between 10 ppm and -30 ppm; and the area ratio of the Si-C resonance peak to the silicon peak is 0.05-6.0.

In a second aspect, an embodiment of the present invention provides a preparation method for the multi-hierarchical composite material prepared at an ultra-high temperature as described in the first aspect. The preparation method is a thermal plasma process, which comprises:
placing a porous carbon material in a condensation zone of a high-frequency plasma processing device, and placing a micron-scale silicon powder and one or more substances containing a doping element in a high-temperature zone of the high-frequency plasma processing device according to the mass ratio of 1:0.1-1:1, the doping element comprising at least one of C, N, B, P, S, Mg, Ca, Al, Zn, Mn, Ni or Ti;
introducing a protective gas into the high-frequency plasma processing device to replace air;
turning on a plasma generator of the high-frequency plasma processing device to ionize a working gas, so that the micron-scale silicon powder and the substances containing the doping element are gasified and dissociated to form a plasma gas having a temperature of 5000 K or more; and
transporting the plasma gas to the condensation zone by using a carrier gas, so that the silicon element and the doping element are deposited in pores of the porous carbon material, allowing for nucleation and growth into a nanometer size, thereby obtaining the multi-hierarchical composite material prepared at an ultra-high temperature.

The method further comprises: performing carbon coating by means of at least one of gas-phase coating, liquid-phase coating and solid-phase coating.

Preferably, the micron-scale silicon powder is micron-scale industrial silicon powder, comprising one or more of residual silicon powder from diamond wire cutting, waste silicon powder from organosilicone production or industrial silicon powder, and the particle size D50 of the micron-scale industrial silicon powder is 5-100 µm.

Preferably,
the substance containing the doping element C comprises one or more of carbon black, acetylene, methane, propylene, ethylene, propane and gaseous ethanol;
the substance containing the doping element N comprises one or more of nitrogen, ammonia, urea, melamine and hydrazine;
the substance containing the doping element B comprises one or more of elemental boron, diborane, trimethyl borate, tripropyl borate and boron tribromide; and
the substance containing the doping element P comprises one or two of white phosphorus, red phosphorus, black phosphorus, phosphine and phosphorus oxychloride;
the substance containing the doping element S comprises one or more of sulfur, thiourea, mercaptan, thiophenol and thioether;
the substance containing the doping element Mg comprises one or more of elemental magnesium, magnesium oxide and magnesium chloride;
the substance containing the doping element Ca comprises one or more of calcium oxide, calcium hydroxide and calcium chloride;
the substance containing the doping element Al comprises one or more of elemental aluminium, aluminium oxide and aluminium chloride;
the substance containing the doping element Zn comprises one or more of elemental zinc, zinc oxide, zinc hydroxide and zinc chloride;
the substance containing the doping element Mn comprises one or more of manganese oxide, manganese hydroxide and manganese chloride;
the substance containing the doping element Ni comprises one or more of elemental nickel, nickel oxide, nickel hydroxide and nickel chloride; and
the substance containing the doping element Ti comprises one or more of elemental titanium, titanium oxide, titanium hydroxide and titanium chloride.

In a third aspect, an embodiment of the present invention provides the use of the multi-hierarchical composite material prepared at an ultra-high temperature as described in the first aspect. The multi-hierarchical composite material is used as a negative electrode material of a lithium ion battery.

In a fourth aspect, an embodiment of the present invention provides a lithium ion battery made of the multi-hierarchical composite material prepared at an ultra-high temperature as described in the first aspect.

According to the multi-hierarchical composite material prepared at an ultra-high temperature, and the preparation method therefor and the use thereof provided by the embodiments of the present invention, by utilizing high-temperature plasma, the silicon material and doping elements are enabled to undergo in-situ nucleation and growth in porous carbon. The doping elements are uniformly embedded and distributed at an atomic scale, thereby enhancing the structural stability of the material during lithium deintercalation and minimizing volume expansion. When used as a negative electrode in lithium batteries, the material exhibits superior cycle performance. The multi-hierarchical composite material of the present invention, featuring a three-layer structure comprising the carbon matrix, the nano-silicon-based composite material, and the carbon shell, as well as the interactions between the composite materials, demonstrates excellent characteristics such as minimal volume expansion, superior cycle performance, and enhanced rate capability. Furthermore, the material is prepared using the thermal plasma method, which is safer than the commonly used CVD method.

### BRIEF DESCRIPTION OF THE SEVERAL VIEWS OF THE DRAWINGS

The technical solutions of the embodiments of the present invention will be described in further detail with reference to the drawings and embodiments.
Fig. 1 is a flowchart of a preparation method for a multi-hierarchical composite material prepared at an ultra-high temperature provided by an embodiment of the present invention;
Fig. 2 is a structural diagram of a multi-hierarchical composite material prepared at an ultra-high temperature provided by an embodiment of the present invention;
Fig. 3 is a solid-state nuclear magnetic resonance (NMR) spectrum of a multi-hierarchical composite material provided in Embodiment 1 of the invention;
Fig. 4 is an X-ray diffraction (XRD) pattern of a multi-hierarchical composite material provided in Embodiment 1 of the present invention; and
Fig. 5 is a charge-discharge graph of a multi-hierarchical composite material provided in Embodiment 1 of the present invention.

### DETAILED DESCRIPTION OF THE INVENTION

The present invention will be further explained below by referring to drawings and specific embodiments, but it should be understood that these embodiments are merely for more detailed explanation, and should not be understood as limiting the present invention in any way, that is, not intended to limit the scope of protection of the present invention.

An embodiment of the present invention provides a multi-hierarchical composite material prepared at an ultra-high temperature, which comprises a carbon matrix and a nano-silicon-based composite material;
the nano-silicon-based composite material is prepared by means of a thermal plasma process, which comprises: bombarding and ionizing a micron-scale silicon powder and one or more substances containing any doping element of C, N, B, P, S, Mg, Ca, Al, Zn, Mn, Ni and Ti in a high-frequency plasma processing device to form a plasma gas having a temperature of 5000 K or more, and then cooling same and depositing same into a core, thereby obtaining a nanoscale silicon-based composite material with doping elements uniformly embedded and distributed at an atomic scale;
the carbon matrix is a porous carbon material, preferably a porous hard carbon material; and the nano-silicon-based composite material is deposited in the porous structure of the carbon matrix.

The particle size of the nano-silicon-based composite material is 0.1-200 nm, and the nano-silicon-based composite material accounts for 10-90% of the mass of the multi-hierarchical composite material; the mass of the doping elements accounts for 0.1-50% of the mass of the nano-silicon-based composite material; and the mass of the carbon matrix accounts for 10-70% of the mass of the multi-hierarchical composite material.

The multi-hierarchical composite material further comprises a carbon shell, an outer layer of the carbon matrix where the nano-silicon-based composite material is deposited is coated with the carbon shell, and the mass of the carbon shell accounts for 0-10% of the mass of the multi-hierarchical composite material.

When the multi-hierarchical composite material contains the element C, the solid-state nuclear magnetic resonance (NMR) spectrum of the multi-hierarchical composite material shows that when a silicon peak is between -65 ppm and -140 ppm, there is a Si-C resonance peak between 10 ppm and -30 ppm; and the area ratio of the Si-C resonance peak to the silicon peak is 0.05-6.0.

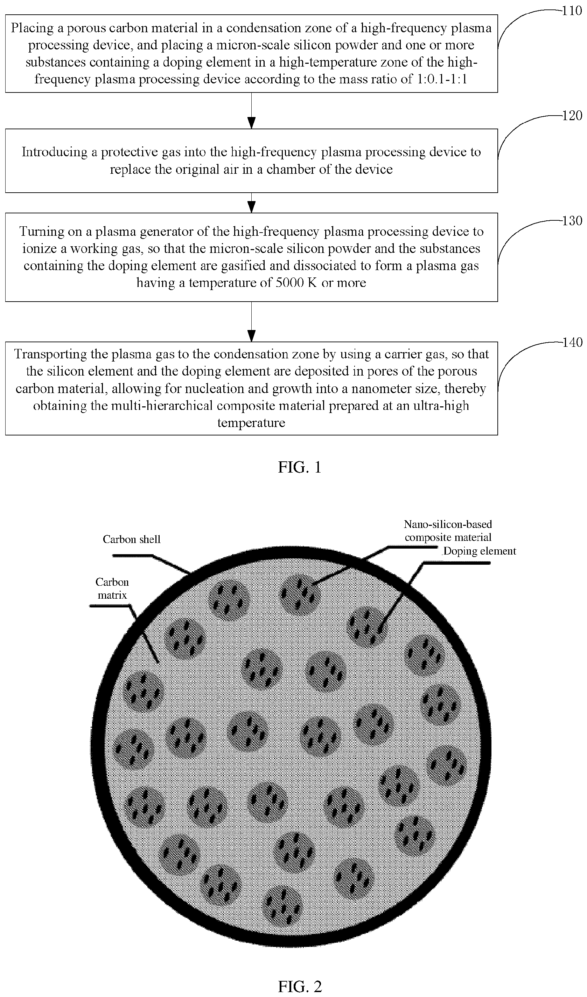

The aforementioned multi-hierarchical composite material can be prepared by a thermal plasma method which, as shown in Fig. 1, comprises:

Step 110, placing a porous carbon material in a condensation zone of a high-frequency plasma processing device, and placing a micron-scale silicon powder and one or more substances containing a doping element in a high-temperature zone of the high-frequency plasma processing device according to the mass ratio of 1:0.1-1:1,
the doping element comprising at least one of C, N, B, P, S, Mg, Ca, Al, Zn, Mn, Ni or Ti;

Step 120, introducing a protective gas into the high-frequency plasma processing device to replace the original air in a chamber of the device,
the protective gas being nitrogen or argon, and the flow rate of the protective gas being 0.5m³/h-3 m³/h;

Step 130, turning on a plasma generator of the high-frequency plasma processing device to ionize a working gas, so that the micron-scale silicon powder and the substances containing the doping element are gasified and dissociated to form a plasma gas having a temperature of 5000 K or more,
the working gas being nitrogen or argon, the flow rate of the working gas being 3m³/h-8 m³/h, and the working gas being ionized to bombard the micron-scale silicon powder and the substances containing the doping element, so that they are gasified and dissociated under the action of high-temperature plasma; and

Step 140, transporting the plasma gas to the condensation zone by using a carrier gas, so that the silicon element and the doping element are deposited in pores of the porous carbon material, allowing for nucleation and growth into a nanometer size, thereby obtaining the multi-hierarchical composite material prepared at an ultra-high temperature,
the carrier gas being nitrogen or argon, and the flow rate of the carrier gas being 0.1m³/h-1 m³/h. By-products from the gasification and dissociation of the substances containing the doping element are finally discharged along with the exhaust gas, carried by the carrier gas.

Optionally, carbon coating can be performed on the obtained material by means of at least one of gas-phase coating, liquid-phase coating and solid-phase coating.

In the above preparation method, the working frequency of the high-frequency plasma processing device is 1MHz-300 MHz. The working voltage is 100V-150 V, and the current is 80A-180 A. The following embodiments of the present invention are realized by using a DLZ-MA-300-B plasma generator as the high-frequency plasma processing device. The choice of different gases, especially the setting of flow rates, may vary for different devices, and those skilled in the art should be aware of how to do it.

The temperature of plasma refers to the ion temperature and electron temperature of equilibrium plasma, also known as thermal plasma. In specific embodiments, the temperature of plasma can range from 5000 K to 20000 K, or even higher.

The micron-scale silicon powder is micron-scale industrial silicon powder with a particle size D50 of 5-100 µm, comprising one or more of residual silicon powder from diamond wire cutting of silicon materials, waste silicon powder from organosilicone production or industrial silicon powder. The utilization of residual silicon powder from cutting or waste silicon powder from production can further contribute to cost reduction, and since the micron-scale silicon powder needs to be gasified and ionized during the preparation process, the use of residual silicon powder from cutting or waste silicon powder from production will not compromise the product quality.

The substances containing the doping element used in Step 110 can be selected as follows:
the substance containing the doping element C comprises one or more of carbon black, acetylene, methane, propylene, ethylene, propane and gaseous ethanol;
the substance containing the doping element N comprises one or more of nitrogen, ammonia, urea, melamine and hydrazine;
the substance containing the doping element B comprises one or more of elemental boron, diborane, trimethyl borate, tripropyl borate and boron tribromide; and
the substance containing the doping element P comprises one or two of white phosphorus, red phosphorus, black phosphorus, phosphine and phosphorus oxychloride;
the substance containing the doping element S comprises one or more of sulfur, thiourea, mercaptan, thiophenol and thioether;
the substance containing the doping element Mg comprises one or more of elemental magnesium, magnesium oxide and magnesium chloride;
the substance containing the doping element Ca comprises one or more of calcium oxide, calcium hydroxide and calcium chloride;
the substance containing the doping element Al comprises one or more of elemental aluminium, aluminium oxide and aluminium chloride;
the substance containing the doping element Zn comprises one or more of elemental zinc, zinc oxide, zinc hydroxide and zinc chloride;
the substance containing the doping element Mn comprises one or more of manganese oxide, manganese hydroxide and manganese chloride;
the substance containing the doping element Ni comprises one or more of elemental nickel, nickel oxide, nickel hydroxide and nickel chloride; and
the substance containing the doping element Ti comprises one or more of elemental titanium, titanium oxide, titanium hydroxide and titanium chloride.

The structural diagram of the multi-hierarchical composite material prepared at an ultra-high temperature prepared by the above method is shown in Fig. 2. As shown in Fig. 2, by utilizing high-temperature plasma, the silicon material and doping elements are enabled to undergo in-situ nucleation and growth in porous carbon. The doping elements are uniformly embedded and distributed at an atomic scale, thereby enhancing the structural stability of the material during lithium deintercalation and minimizing volume expansion. When used as a negative electrode in lithium batteries, the material exhibits superior cycle performance. The multi-hierarchical composite material of the present invention, featuring a three-layer structure comprising the carbon matrix, the nano-silicon-based composite material, and the carbon shell, as well as the interactions between the composite materials, demonstrates excellent characteristics such as minimal volume expansion, superior cycle performance, and enhanced rate capability. Furthermore, the material is prepared using the thermal plasma method, which is safer than the commonly used CVD method.

The multi-hierarchical composite material prepared at an ultra-high temperature provided by the embodiment of the present invention can be used as an anode material of a lithium ion battery, especially as an anode active material, and the anode material can be applied to a lithium ion battery.

In order to better understand the technical scheme provided by the present invention, the preparation process and characteristics of the multi-hierarchical composite material prepared at an ultra-high temperature are described below with several specific examples.

### Embodiment 1

This embodiment provides a preparation method for a multi-hierarchical composite material prepared at an ultra-high temperature. The method comprises: placing a porous hard carbon material in a condensation zone of a high-frequency plasma processing device, and placing a residual silicon powder from diamond wire cutting and carbon black in a high-temperature zone of the high-frequency plasma processing device according to a ratio of 1:0.1; introducing a protective gas into the high-frequency plasma processing device to replace air, and turning on a plasma generator of the high-frequency plasma processing device to ionize a working gas, allowing the silicon powder to be gasified and subjecting acetylene to high-temperature gasification and dissociation; transporting the gaseous silicon and the plasma gaseous substance containing C into the condensation zone by using a carrier gas, so that silicon and C doped into silicon are deposited in pores of the porous hard carbon material, allowing for nucleation and growth into a nanometer size; and finally, performing carbon coating on the product obtained after deposition by gas-phase coating, thereby obtaining the multi-hierarchical composite material prepared at an ultra-high temperature.

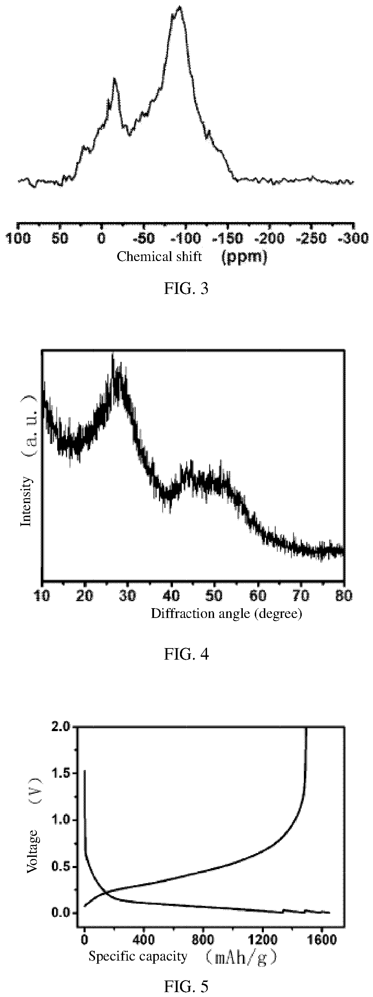

The solid-state NMR spectrum of the multi-hierarchical composite material prepared at an ultra-high temperature prepared by this embodiment is shown in Fig. 3. It can be seen that when a silicon peak is between -65 ppm and -140 ppm, there is a Si-C resonance peak between 10 ppm and -30 ppm; and the area ratio of the Si-C resonance peak to the silicon peak is 0.05-6.0 from the solid-state NMR spectrum of the multi-hierarchical composite material.

The XRD pattern of the multi-hierarchical composite material prepared at an ultra-high temperature prepared by this embodiment is shown in Fig. 4.

The obtained multi-hierarchical composite material serving as an negative material, carbon black serving as a conductive additive, and a binder (sodium carboxymethyl cellulose and butadiene styrene rubber in a 1:1 ratio) were weighed according to the ratio of 95:2:3. Slurry was prepared in a beater at room temperature. The prepared slurry was evenly applied to copper foil. After being dried in a blast drying oven at 50°C for 2 hours, the material was cut into 8×8 mm pole pieces, and then vacuum drying was performed in a vacuum drying oven at 100°C for 10 hours. The dried pole pieces were immediately transferred into a glove box for battery assembly.

Simulateing battery assembly was performed in a glove box containing high purity Ar atmosphere. Lithium metal serves as a counter electrode and ethylene carbonate (EC)/dimethyl carbonate (DMC) containing a solution of 1 mol LiPF₆ in(v:v=1:1) is as an electrolyte, and batteries are assembled. A constant current charge-discharge mode test was carried out by using a charge-discharge instrument. The discharge cut-off voltage was 0.005 V and the charge cut-off voltage was 1.5 V. The charge-discharge test was carried out at C/10 current density. The charge-discharge graph of the multi-hierarchical composite material prepared at an ultra-high temperature prepared by this embodiment is shown in Fig. 5. The initial-cycle discharge capacity is 1494 mAh/g, and the initial-cycle efficiency is 90.65%.

To facilitate comparison, we prepared a control sample using the following method.

### Comparative example 1

This comparative example provides a preparation method for a common silicon-carbon composite material, comprising the following steps:

Step 1, placing 200 g of nano silicon particles and 500 g of phenolic resin powder in a hydrothermal reactor for hydrothermal reaction, wherein the pressure was 5 Mpa, the heating temperature was 300°C, and the temperature was kept for 8 hours, then cleaning and filtering discharged materials until a filtrate became transparent and colorless, and then drying to obtain a spherical silicon-containing carbonized precursor; and

Step 2, mixing the samples obtained in Step 1 and putting them into a reaction device for carbonization treatment, with the temperature raised to 900°C at 3°C/min, and the temperature kept for 6 hours in a nitrogen atmosphere, so as to obtain a common silicon-carbon composite material.

The obtained material was used for battery assembly and testing, and the specific process was the same as in Embodiment 1. The test data are recorded in Table 1.

### Embodiment 2

This embodiment provides a preparation method for a multi-hierarchical composite material prepared at an ultra-high temperature. The method comprises: placing a porous hard carbon material in a condensation zone of a high-frequency plasma processing device, and placing a waste silicon powder from organosilicone production and methane and ammonia containing C and N in a high-temperature zone of the high-frequency plasma processing device according to a ratio of 1:0.1:0.1; introducing a protective gas into the high-frequency plasma processing device to replace air, and turning on a plasma generator of the high-frequency plasma processing device to ionize a working gas, allowing the silicon powder to be gasified and subjecting methane and ammonia to high-temperature gasification and dissociation; transporting the gaseous silicon and the plasma gaseous substance containing C and N into the condensation zone by using a carrier gas, so that silicon and C and N doped into silicon are deposited in pores of the porous hard carbon material, allowing for nucleation and growth into a nanometer size; and finally, performing carbon coating on the product obtained after deposition by liquid-phase coating, thereby obtaining the multi-hierarchical composite material prepared at an ultra-high temperature.

The obtained material was used for battery assembly and testing, and the process was same as in Embodiment 1. The test data are recorded in Table 1.

### Embodiment 3

This embodiment provides a preparation method for a multi-hierarchical composite material prepared at an ultra-high temperature. The method comprises: placing a porous hard carbon material in a condensation zone of a high-frequency plasma processing device, and placing an industrial silicon powder and propylene, urea, diborane and phosphine containing C, N, B and P in a high-temperature zone of the high-frequency plasma processing device according to a ratio of 1:0.075:0.075:0.075:0.075; introducing a protective gas into the high-frequency plasma processing device to replace air, and turning on a plasma generator of the high-frequency plasma processing device to ionize a working gas, allowing the silicon powder to be gasified and subjecting propylene, urea, diborane and phosphine to high-temperature gasification and dissociation; transporting the gaseous silicon and the plasma gaseous substance containing C, N, B and P into the condensation zone by using a carrier gas, so that silicon and C, N, B and P doped into silicon are deposited in pores of the porous hard carbon material, allowing for nucleation and growth into a nanometer size; and finally, performing carbon coating on the product obtained after deposition by solid-phase coating, thereby obtaining the multi-hierarchical composite material prepared at an ultra-high temperature.

The obtained material was used for battery assembly and testing, and the process was same as in Embodiment 1. The test data are recorded in Table 1.

### Embodiment 4

This embodiment provides a preparation method for a multi-hierarchical composite material prepared at an ultra-high temperature. The method comprises: placing a porous hard carbon material in a condensation zone of a high-frequency plasma processing device, and placing a residual material from diamond wire cutting and ethylene, thiourea, magnesium oxide and calcium oxide containing C, S, Mg and Ca in a high-temperature zone of the high-frequency plasma processing device according to a ratio of 1:0.1:0.1:0.1:0.1; introducing a protective gas into the high-frequency plasma processing device to replace air, and turning on a plasma generator of the high-frequency plasma processing device to ionize a working gas, allowing the silicon powder to be gasified and subjecting ethylene, thiourea, magnesium oxide and calcium oxide to high-temperature gasification and dissociation; transporting the gaseous silicon and the plasma gaseous substance containing C, S, Mg and Ca into the condensation zone by using a carrier gas, so that silicon and C, S, Mg and Ca doped into silicon are deposited in pores of the porous hard carbon material, allowing for nucleation and growth into a nanometer size; and performing carbon coating on the product obtained after deposition by gas-phase coating, thereby obtaining the multi-hierarchical composite material prepared at an ultra-high temperature.

The obtained material was used for battery assembly and testing, and the process was same as in Embodiment 1. The test data are recorded in Table 1.

### Embodiment 5

This embodiment provides a preparation method for a multi-hierarchical composite material prepared at an ultra-high temperature. The method comprises: placing a porous hard carbon material in a condensation zone of a high-frequency plasma processing device, and placing a waste silicon powder from organosilicone production and propane, aluminium oxide, zinc oxide and manganese oxide containing C, Al, Zn and Mn in a high-temperature zone of the high-frequency plasma processing device according to a ratio of 1:0.125:0.125:0.125:0.125; introducing a protective gas into the high-frequency plasma processing device to replace air, and turning on a plasma generator of the high-frequency plasma processing device to ionize a working gas, allowing the silicon powder to be gasified and subjecting propane, aluminium oxide, zinc oxide and manganese oxide to high-temperature gasification and dissociation; transporting the gaseous silicon and the plasma gaseous substance containing C, Al, Zn and Mn into the condensation zone by using a carrier gas, so that silicon and C, Al, Zn and Mn doped into silicon are deposited in pores of the porous hard carbon material, allowing for nucleation and growth into a nanometer size; and performing carbon coating on the product obtained after deposition by liquid-phase coating, thereby obtaining the multi-hierarchical composite material prepared at an ultra-high temperature.

The obtained material was used for battery assembly and testing, and the process was same as in Embodiment 1. The test data are recorded in Table 1.

### Embodiment 6

This embodiment provides a preparation method for a multi-hierarchical composite material prepared at an ultra-high temperature. The method comprises: placing a porous hard carbon material in a condensation zone of a high-frequency plasma processing device, and placing an industrial silicon powder and substance such as zinc hydroxide, manganese hydroxide, nickel hydroxide and titanium oxide containing Zn, Mn, Ni and Ti in a high-temperature zone of the high-frequency plasma processing device according to a ratio of 1:0.15:0.15:0.15:0.15; introducing a protective gas into the high-frequency plasma processing device to replace air, and turning on a plasma generator of the high-frequency plasma processing device to ionize a working gas, allowing the silicon powder to be gasified and subjecting zinc hydroxide, manganese hydroxide, nickel hydroxide and titanium oxide to high-temperature gasification and dissociation; transporting the gaseous silicon and the plasma gaseous substance containing Zn, Mn, Ni and Ti into the condensation zone by using a carrier gas, so that silicon and Zn, Mn, Ni and Ti doped into silicon are deposited in pores of the porous hard carbon material, allowing for nucleation and growth into a nanometer size; and performing carbon coating on the product obtained after deposition by solid-phase coating, thereby obtaining the multi-hierarchical composite material prepared at an ultra-high temperature.

The obtained material was used for battery assembly and testing, and the process was same as in Embodiment 1. The test data are recorded in Table 1.

### Embodiment 7

This embodiment provides a preparation method for a multi-hierarchical composite material prepared at an ultra-high temperature. The method comprises: placing a porous hard carbon material in a condensation zone of a high-frequency plasma processing device, and placing a residual silicon powder from diamond wire cutting, a waste silicon powder from organosilicone production, and ethanol and titanium hydroxide containing C and Ti in a high-temperature zone of the high-frequency plasma processing device according to a ratio of 1:0.35:0.35; introducing a protective gas into the high-frequency plasma processing device to replace air, and turning on a plasma generator of the high-frequency plasma processing device to ionize a working gas, allowing the silicon powder to be gasified and subjecting ethanol and titanium hydroxide to high-temperature gasification and dissociation; transporting the gaseous silicon and the plasma gaseous substance containing C and Ti into the condensation zone by using a carrier gas, so that silicon and C and Ti doped into silicon are deposited in pores of the porous hard carbon material, allowing for nucleation and growth into a nanometer size; and performing carbon coating on the product obtained after deposition by gas-phase coating, thereby obtaining the multi-hierarchical composite material prepared at an ultra-high temperature.

The obtained material was used for battery assembly and testing, and the process was same as in Embodiment 1. The test data are recorded in Table 1.

### Embodiment 8

This embodiment provides a preparation method for a multi-hierarchical composite material prepared at an ultra-high temperature. The method comprises: placing a porous hard carbon material in a condensation zone of a high-frequency plasma processing device, and placing a residual silicon powder from diamond wire cutting, an industrial silicon powder, and acetylene and nickel oxide containing C and Ni in a high-temperature zone of the high-frequency plasma processing device according to a ratio of 1:0.4:0.4; introducing a protective gas into the high-frequency plasma processing device to replace air, and turning on a plasma generator of the high-frequency plasma processing device to ionize a working gas, allowing the silicon powder to be gasified and subjecting acetylene and nickel oxide to high-temperature gasification and dissociation; transporting the gaseous silicon and the plasma gaseous substance containing C and Ni into the condensation zone by using a carrier gas, so that silicon and C and Ni doped into silicon are deposited in pores of the porous hard carbon material, allowing for nucleation and growth into a nanometer size; and performing carbon coating on the product obtained after deposition by liquid-phase coating, thereby obtaining the multi-hierarchical composite material prepared at an ultra-high temperature.

The obtained material was used for battery assembly and testing, and the process was same as in Embodiment 1. The test data are recorded in Table 1.

### Embodiment 9

This embodiment provides a preparation method for a multi-hierarchical composite material prepared at an ultra-high temperature. The method comprises: placing a porous hard carbon material in a condensation zone of a high-frequency plasma processing device, and placing a waste silicon powder from organosilicone production, an industrial silicon powder, and methane and manganese chloride containing C and Mn in a high-temperature zone of the high-frequency plasma processing device according to a ratio of 1:0.45:0.45; introducing a protective gas into the high-frequency plasma processing device to replace air, and turning on a plasma generator of the high-frequency plasma processing device to ionize a working gas, allowing the silicon powder to be gasified and subjecting methane and manganese chloride to high-temperature gasification and dissociation; transporting the gaseous silicon and the plasma gaseous substance containing C and Mn into the condensation zone by using a carrier gas, so that silicon and C and Mn doped into silicon are deposited in pores of the porous hard carbon material, allowing for nucleation and growth into a nanometer size; and performing carbon coating on the product obtained after deposition by solid-phase coating, thereby obtaining the multi-hierarchical composite material prepared at an ultra-high temperature.

The obtained material was used for battery assembly and testing, and the process was same as in Embodiment 1. The test data are recorded in Table 1.

### Embodiment 10

This embodiment provides a preparation method for a multi-hierarchical composite material prepared at an ultra-high temperature. The method comprises: placing a porous carbon material in a condensation zone of a high-frequency plasma processing device, and placing a residual silicon powder from diamond wire cutting, a waste silicon powder from organosilicone production, an industrial silicon powder, and propylene and zinc chloride containing C and Zn in a high-temperature zone of the high-frequency plasma processing device according to a ratio of 1:0.5:0.5; introducing a protective gas into the high-frequency plasma processing device to replace air, and turning on a plasma generator of the high-frequency plasma processing device to ionize a working gas, allowing the silicon powder to be gasified and subjecting propylene and zinc chloride to high-temperature gasification and dissociation; transporting the gaseous silicon and the plasma gaseous substance containing C and Zn into the condensation zone by using a carrier gas, so that silicon and the gaseous compound of C and Zn doped into silicon are deposited in pores of the porous hard carbon material, allowing for nucleation and growth into a nanometer size; and performing carbon coating on the product obtained after deposition by gas-phase coating, thereby obtaining the multi-hierarchical composite material prepared at an ultra-high temperature.

The obtained material was used for battery assembly and testing, and the process was same as in Embodiment 1. The test data are recorded in Table 1.

**Table 1**

| No. | Charge specific capacity (mAh/g) | First-cycle efficiency (%) |
|---|---|---|
| Embodiment 1 | 1494 | 90.65 |
| Embodiment 2 | 1489 | 91.65 |
| Embodiment 3 | 1484 | 91.67 |
| Embodiment 4 | 1482 | 91.76 |
| Embodiment 5 | 1481 | 91.94 |
| Embodiment 6 | 1474 | 92.04 |
| Embodiment 7 | 1470 | 92.06 |
| Embodiment 8 | 1469 | 92.39 |
| Embodiment 9 | 1465 | 92.59 |
| Embodiment 10 | 1448 | 92.82 |
| Comparative example 1 | 1212 | 78.92 |

The composite materials obtained in the above embodiments and comparative example were compounded with commercial graphite in proportion to form composite materials of 450 mAh/g, which were then assembled with lithium cobalt oxides to form button-type full cells; and the button-type full cells were made to cycle at 1C to evaluate the cycle performance. Data are recorded in Table 2.

**Table 2**

| No. | Charge specific capacity (mAh/g) | initial-cycle efficiency (%) | Capacity retention rate (Cycle 300 times) |
|---|---|---|---|
| Embodiment 1 | 451 | 92.17 | 92.03 |
| Embodiment 2 | 452 | 92.20 | 92.14 |
| Embodiment 3 | 449 | 92.32 | 92.22 |
| Embodiment 4 | 457 | 92.35 | 92.68 |
| Embodiment 5 | 455 | 92.46 | 92.65 |
| Embodiment 6 | 450 | 92.80 | 92.63 |
| Embodiment 7 | 453 | 92.91 | 92.66 |
| Embodiment 8 | 446 | 93.23 | 92.17 |
| Embodiment 9 | 449 | 94.01 | 92.94 |
| Embodiment 10 | 453 | 93.39 | 92.97 |
| Comparative example 1 | 451 | 92.03 | 70.73 |

It can be seen from the comparison of the comparative example and the embodiments that the multi-hierarchical composite material prepared at an ultra-high temperature provided by the present invention has higher specific capacity and intial-cycle efficiency. Moreover, when assessing the cycle performance of full cells, the multi-hierarchical composite material prepared at an ultra-high temperature provided by the present invention exhibited superior cycle performance. By utilizing a three-layer structure consisting of the carbon matrix, the nano-silicon-based composite material and the carbon shell, as well as the interactions among the composite materials, this composite material exhibits small volume expansion and better cycle performance and rate performance. Furthermore, by adjusting the ratio of deposited silicon to doping elements, it can be observed that with an increase in the proportion of doping elements, although the charge specific capacity decreases, the inital-cycle efficiency continuously improves. Through the thermal plasma method, silicon is doped with one or more of C, N, B, P, S, Mg, Ca, Al, Zn, Mn, Ni, and Ti, resulting in a more stable structure and minimal volume expansion during lithium deintercalation. When used as a negative electrode in lithium batteries, this material exhibits improved cycle performance.

The above-mentioned embodiments further explain the purpose, technical solution and beneficial effects of the present invention in detail. It should be understood that the above are only specific embodiments of the present invention and are not used to limit the scope of protection of the present invention. Any modification, equivalent substitution, improvement, etc. made within the spirit and principles of the present invention should be included in the scope of protection of the invention.

## Claims

1. A multi-hierarchical composite material prepared at an ultra-high temperature, wherein the multi-hierarchical composite material comprises a carbon matrix and a nano-silicon-based composite material;
the nano-silicon-based composite material is prepared by means of a thermal plasma process, which comprises: bombarding and ionizing a micron-scale silicon powder and one or more substances containing a doping element in a high-frequency plasma processing device to form a plasma gas having a temperature of 5000 K or more, and then cooling same and depositing same into a core, thereby obtaining a nanoscale silicon-based composite material with doping elements uniformly embedded and distributed at an atomic scale; the doping element comprises at least one of C, N, B, P, S, Mg, Ca, Al, Zn, Mn, Ni or Ti;
the carbon matrix is a porous carbon material; and the nano-silicon-based composite material is deposited in the porous structure of the carbon matrix.

2. The multi-hierarchical composite material according to Claim 1, wherein the particle size of the nano-silicon-based composite material is 0.1nm-200nm, and the nano-silicon-based composite material accounts for 10-90% of the mass of the multi-hierarchical composite material; the mass of the doping elements accounts for 0.1-50% of the mass of the nano-silicon-based composite material; and the mass of the carbon matrix accounts for 10-70% of the mass of the multi-hierarchical composite material.

3. The multi-hierarchical composite material according to Claim 2, wherein the multi-hierarchical composite material further comprises a carbon shell, an outer layer of the carbon matrix where the nano-silicon-based composite material is deposited is coated with the carbon shell, and the mass of the carbon shell accounts for 0-10% of the mass of the multi-hierarchical composite material.

4. The multi-hierarchical composite material according to Claim 1, wherein when the multi-hierarchical composite material contains the element C, the solid-state nuclear magnetic resonance (NMR) spectrum of the multi-hierarchical composite material shows that when a silicon peak is between -65 ppm and -140 ppm, there is a Si-C resonance peak between 10 ppm and -30 ppm; and the area ratio of the Si-C resonance peak to the silicon peak is 0.05-6.0.

5. A preparation method for the multi-hierarchical composite material prepared at an ultra-high temperature according to any one of Claims 1-4, wherein the preparation method is a thermal plasma method, which comprises:
placing a porous carbon material in a condensation zone of a high-frequency plasma processing device, and placing a micron-scale silicon powder and one or more substances containing a doping element in a high-temperature zone of the high-frequency plasma processing device according to the mass ratio of 1:0.1-1:1, the doping element comprising at least one of C, N, B, P, S, Mg, Ca, Al, Zn, Mn, Ni or Ti;
introducing a protective gas into the high-frequency plasma processing device to replace air;
turning on a plasma generator of the high-frequency plasma processing device to ionize a working gas, so that the micron-scale silicon powder and the substances containing the doping element are gasified and dissociated to form a plasma gas having a temperature of 5000 K or more; and
transporting the plasma gas to the condensation zone by using a carrier gas, so that the silicon element and the doping element are deposited in pores of the porous carbon material, allowing for nucleation and growth into a nanometer size, thereby obtaining the multi-hierarchical composite material prepared at an ultra-high temperature.

6. The preparation method for the multi-hierarchical composite material according to Claim 5, wherein the method further comprises: performing carbon coating by means of at least one of gas-phase coating, liquid-phase coating and solid-phase coating.

7. The preparation method according to Claim 5, wherein the micron-scale silicon powder is micron-scale industrial silicon powder, comprising one or more of residual silicon powder from diamond wire cutting, waste silicon powder from organosilicone production or industrial silicon powder, and the particle size D50 of the micron-scale industrial silicon powder is 5-100 µm.

8. The preparation method according to Claim 5, wherein
the substance containing the doping element C comprises one or more of carbon black, acetylene, methane, propylene, ethylene, propane and gaseous ethanol;
the substance containing the doping element N comprises one or more of nitrogen, ammonia, urea, melamine and hydrazine;
the substance containing the doping element B comprises one or more of elemental boron, diborane, trimethyl borate, tripropyl borate and boron tribromide; and
the substance containing the doping element P comprises one or two of white phosphorus, red phosphorus, black phosphorus, phosphine and phosphorus oxychloride;
the substance containing the doping element S comprises one or more of sulfur, thiourea, mercaptan, thiophenol and thioether;
the substance containing the doping element Mg comprises one or more of elemental magnesium, magnesium oxide and magnesium chloride;
the substance containing the doping element Ca comprises one or more of calcium oxide, calcium hydroxide and calcium chloride;
the substance containing the doping element Al comprises one or more of elemental aluminium, aluminium oxide and aluminium chloride;
the substance containing the doping element Zn comprises one or more of elemental zinc, zinc oxide, zinc hydroxide and zinc chloride;
the substance containing the doping element Mn comprises one or more of manganese oxide, manganese hydroxide and manganese chloride;
the substance containing the doping element Ni comprises one or more of elemental nickel, nickel oxide, nickel hydroxide and nickel chloride; and
the substance containing the doping element Ti comprises one or more of elemental titanium, titanium oxide, titanium hydroxide and titanium chloride.

9. A use of the multi-hierarchical composite material prepared at an ultra-high temperature according to any one of Claims 1-4, wherein the multi-hierarchical composite material is used as a negative electrode material of a lithium ion battery.

10. A lithium ion battery comprising the multi-hierarchical composite material prepared at an ultra-high temperature according to any one of Claims 1-4.
